# EUROPÄISCHE PATENTSCHRIFT

(11) **EP 0 859 401 B1**
(45) Veröffentlichungstag und Bekanntmachung des Hinweises auf die Patenterteilung: **01.12.2004**
(21) Anmeldenummer: 98100724.8
(22) Anmeldetag: 16.01.1998
(51) Int. Cl.: H01L 21/033, H01L 21/336, H01L 21/8249, H01L 27/06, H01L 29/78

(54) **Halbleiterkörper mit selbstjustierender Struktur**
Semiconductor device with a self-aligned structure
Dispositif semiconducteurs avec une structure auto-alignée

(30) Priorität: 12.02.1997 DE 19705351
(43) Veröffentlichungstag der Anmeldung: 19.08.1998
(73) Patentinhaber: Infineon Technologies AG, 81669 München (DE)
(72) Erfinder: Stecher, Mattihas, Dr., 9500 Villach (AT); Peri, Hermann, 9500 Villach (AT)
(74) Vertreter: Patentanwälte Westphal, Mussgnug & Partner

(56) Entgegenhaltungen:
- DE-A- 4 434 108
- US-A- 5 356 826

## Beschreibung

Die Erfindung betrifft ein Verfahren zum Herstellen eines Halbleiterkörpers mit einem eine selbstjustierende Struktur aufweisenden ersten Bereich und einem übrigen zweiten Bereich und folgenden Verfahrensschritten:
- eine erste Oxidschicht wird auf eine obere Hauptfläche des Halbleiterkörpers aufgebracht und strukturiert;
- auf die Oxidschicht wird eine Halbleiterschicht aufgebracht;
- auf die Halbleiterschicht wird eine Isolationsschicht aufgebracht.

Ein solches Verfahren ist beispielsweise aus DE 44 34 108 A1 bekannt. Das Verfahren beschreibt die Erzeugung eines niederohmigen Kontaktes zwischen einer Metallisierungsschicht und einem Halbleitermaterial, bei dem über der Oberfläche des Halbleitermaterials Isolierschichten vorgegebener Dotierung und eine dazwischenliegende Halbleiterschicht aufgebracht und strukturiert werden. Darüber hinaus werden Dotierstoffe unterschiedlicher Leitfähigkeit in den Halbleiterkörper unter Verwendung der strukturierten Schichten als Maske implantiert. Es ergibt sich hierdurch eine kleine Kontaktfläche bei vorgegebenem Strom und ein kleiner Einschaltwiderstand.

Ganz entscheidend bei diesem bekannten Verfahren ist die eingesetzte, sogenannte "selbstjustierende" Technik, bei der eine Halbleiterschicht, z. B. polykristallines hochdotiertes Silizium, als Gatematerial eines MOS-Transistors verwendet und gleichzeitig als Maske für die Source- und Draindotierung benutzt wird (vgl. hierzu auch das Buch R. Müller:

"Bauelemente der Halbleiter-Elektronik"). Zur Strukturierung dieser Halbleiterschicht wird auf diese eine mindestens einlagige Isolierschicht mit einem vorgegebenen Gehalt an Dotierstoffen aufgebracht. Diese Isolierschicht dient als Getterschicht. Die Isolierschicht kann typischerweise eine sogenannte TEOS sein, die anschließend mittels Standard-Fototechnik strukturiert und anisotrop geätzt wird. Unter Verwendung dieser Isolierschicht als Maske wird dann die Halbleiterschicht anisotrop geätzt und die gewünschte Gateform, z. B. Streifen, im MOS-Transistorbereich erzeugt. Anschließend kann eine Implantation eines Dotierstoffes in den Halbleiterkörper durch ein in die Halbleiterschicht geätztes Loch erfolgen.

Obwohl sich dieses bekannte Verfahren hervorragend zum Erzeugen von selbstjustierenden Strukturen in Halbleiterkörpern eignet, hat sich herausgestellt, daß dann Probleme auftreten, wenn in den Halbleiterkörper sowohl Leistungsbauelemente, wie DMOS-Transistoren, und übrige Bauelemente integriert werden sollen. Bei den Leistungs-MOS-Transistoren, wie DMOS-Transistoren, muß nämlich zur Optimierung des Einschaltwiderstandes die erwähnte Technologie mit selbstjustierender Struktur, die das Übereinanderanordnen von Halbleiterschicht und darüberliegender Isolationsschicht erfordert, angewandt werden. Diese erforderliche und auf der Halbleiterschicht sitzende Isolationsschicht ist nämlich etwa doppelt so hoch wie die Halbleiterschicht. Da die Halbleiterschicht auch im übrigen Bereich des Halbleiterkörpers, in dem keine selbstjustierende Struktur notwendig ist, zur Realisierung von Leiterbahnen eingesetzt wird, ergeben sich aufgrund der durch das erwähnte Herstellverfahren gezwungenerweise vorhandenen Auflage der Isolationsschicht auf diesen Leiterbahnen verhältnismäßig hohe Stufen, die von weiteren Metallisierungsebenen überwunden werden müssen. Dies führt zu großen Leiterbahnabständen, Kontaktlöchern auf der Halbleiterschicht, Fertigungs- und Ausbeuteproblemen und demzufolge zu hohen Prozeßkosten.

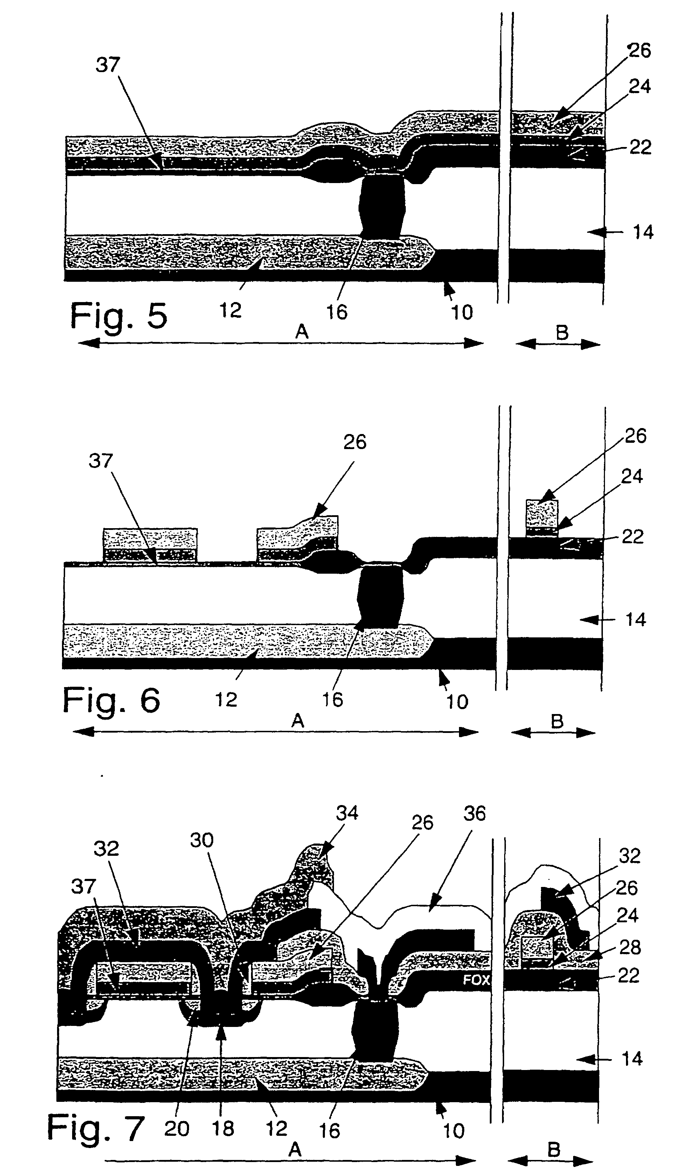

Das Problem der von weiteren Metallisierungsebenen zu überwindenden hohen Stufen, die durch die auf der Halbleiterschicht bisher gezwungenermaßen vorhandenen Isolationsschicht bedingt sind, wird anhand von Schnittbildern durch einen Teil eines Halbleiterkörpers, der nach dem bekannten Verfahren hergestellt ist, verdeutlicht. Die Figuren 5 bis 7 zeigen den Halbleiterkörper in verschiedenen Phasen seiner Herstellung.

Figur 7 zeigt einen Ausschnitt aus einem solchen fertigen Halbleiterkörper, bei welchem der eine selbstjustierende Struktur aufweisende Bereich mit A und der übrige Bereich mit B bezeichnet ist. Im Bereich A ist beispielsweise ein DMOS-Transistor realisiert, während im übrigen Bereich B übereinander angeordnete Metallisierungsebenen eines Widerstandes, einer Diode oder ähnlichem ausschnittsweise dargestellt sind.

Der Halbleiterkörper weist ein p-dotiertes Substrat 10 auf, in das eine sogenannte Buried-Layer 12 eingebettet ist. Die Buried-Layer 12 befindet sich im Bereich A. Von diesen Buried-Layer 12 erstreckt sich vertikal nach oben ein Tiefdiffusionsgebiet 16, das eine leitende Verbindung zwischen dem Buried-Layer 12 und einer ersten Metallisierungsschicht 32 herstellt. Links von dem Tiefdiffusionsgebiet 16 befinden sich zwei p-dotierte Wannen 18, von denen die links dargestellte Wanne 18 lediglich noch halb zu erkennen ist. Diese p-dotierten Wannen 18 sind von der ersten Metallisierungsschicht 32 mittig kontaktiert. Links und rechts von dem an die p-dotierte Wanne 18 durch die Metallisierungsschicht 32 angeformten Kontakt befinden sich n⁺-dotierte Gebiete 20, die die Source eines MOS-Transistors bilden. Auf der oberen Hauptfläche dieses so gestalteten Halbleiterkörpers ist eine Oxidschicht 22 angeordnet, die durch die erwähnten Kontakte, die durch die Metallisierungsschicht 32 an den p-dotierten Wannen 18 und dem Tiefdiffusionsgebiet 16 gebildet sind, unterbrochen ist. Über dieser Oxidschicht 22 befindet sich eine Halbleiterschicht 24, die beispielsweise eine hochdotierte Polysiliziumschicht sein kann. Die Halbleiterschicht 24 ist durch den erwähnten Kontakt der Metallisierungsschicht 32 im Bereich A unterbrochen. Im linken Teil des Bereiches A bildet diese Halbleiterschicht 24 die Gateelektrodenschicht, auf welcher eine mindestens einlagig ausgeführte weitere Isolationsschicht 26 sitzt. Links und rechts der Kanten dieser Übereinanderanordnung von Halbleiterschicht 24 und 26 befinden sich sogenannte Spacer 30, die die Kanten isolierend abdecken. Über dieser erwähnten Struktur verläuft die Metallisierungsschicht 32. In ähnlicher Weise ist die Halbleiterschicht 24 mit darüberliegender Isolationsschicht 26 zwischen dem in Figur 7 rechts dargestellten p-Gebiet 18 und dem Tiefdiffusionsgebiet 16 angeordnet, wobei sich diese Zweilagenschicht aus Halbleiterschicht 24 und Isolationsschicht 26 stufenförmig nach rechts erhebt.

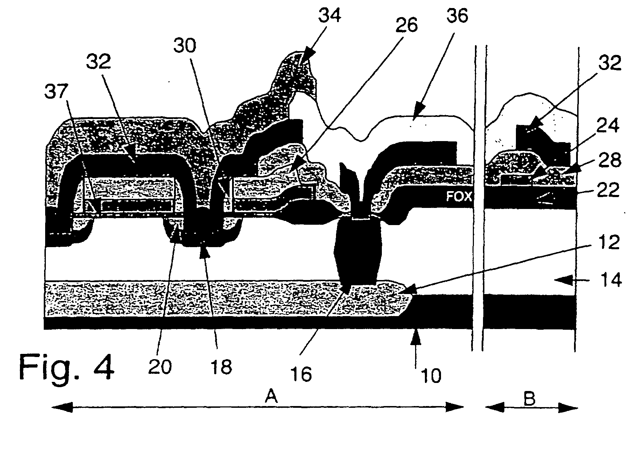

Im zweiten Bereich B des Halbleiterkörpers ist ebenfalls ein strukturierter Ausschnitt der erwähnten Halbleiterschicht 24, hier jedoch zur Realisierung einer Leiterbahn bzw. eines Widerstandes und nicht einer Gateelektrode vorgesehen. Da, wie oben erwähnt, die Strukturierung dieser Halbleiterschicht 24 ausschließlich über die darüberliegende Isolationsschicht 26 erfolgen kann (vgl. Figuren 5 und 6), befindet sich diese notwendigerweise auch im Bereich B auf der Halbleiterschicht 24. Durch diese notwendigerweise vorhandene Isolationsschicht 26 werden verhältnismäßig hohe Stufen im Bereich B erzeugt, die nicht unbedingt erforderlich sind, weil im Bereich B keine selbstjustierende Struktur zur Realisierung von MOS-Transistoren notwendig ist, dort also keine Spacer 30 vorhanden sein müssen. Dennoch muß die Metallisierungsschicht 32 verhältnismäßig hohe Stufen überwinden. Damit eine solche zweite Leiterbahn mittels der Metallisierungsschicht 32 im Bereich B realisiert werden kann, muß - wie Figur 4 zeigt - noch eine zusätzliche Isolationsschicht 28 auf den Halbleiterkörper aufgebracht werden. Erst dann kann die Metallisierungsschicht 32 aufgebracht werden.

Der Vollständigkeit halber ist in Figur 7 noch eine weitere obere Isolationsschicht 36 und eine zweite Metallschicht 34 dargestellt.

Die erwähnten hohen Stufen für die Metallisierungsschicht 32 führen bei der Fertigung von Halbleiterkörpern, auf denen sowohl selbstjustierende Strukturen als auch übrige Bereiche integriert sind, zu erheblichen Problemen. Die hohen Stufen der Metallisierungsschicht, die beispielsweise eine Aluminiumschicht sein kann, führen nämlich zu verhältnismäßig tiefen Ätzvorgängen. Solche tiefen Ätzvorgänge sind aufwendig und in der Herstellung kompliziert. Schließlich ist mit solch hohen Stufen im übrigen Bereich des Halbleiterkörpers eine hohe Packungsdichte von integrierten Bauelementen ausgeschlossen.

Der Erfindung liegt die Aufgabe zugrunde, das eingangs genannte Verfahren zum Herstellen eines Halbleiterkörpers mit einer selbstjustierenden Struktur und einem übrigen Bereich so zu verbessern, daß insgesamt eine höhere Packungsdichte erreicht wird und eine einfachere Herstellung des Halbleiterkörpers möglich ist. Durch das Verfahren sollen Halbleiterkörper herstellbar sein, die zumindest im übrigen Bereich des Halbleiterkörpers verhältnismäßig geringe Leiterbahnabstände ermöglichen.

Diese Aufgabe wird bei dem eingangs genannten Verfahren durch folgende zusätzliche Verfahrensschritte gelöst:
- die Isolationsschicht wird mittels Fototechnik und anschließendem Ätzen so strukturiert, daß diese im zweiten Bereich B vollständig entfernt ist und im ersten Bereich A mindestens teilweise noch auf der Halbleiterschicht sitzt,
- mittels Fototechnik und anschließendem Ätzen wird die Halbleiterschicht und in Abschnitten, bei denen die Isolationsschicht über der Halbleiterschicht sitzt, die Isolationsschicht zusammen mit der Halbleiterschicht strukturiert.

Weiterbildungen der Erfindung sind Gegenstand der Unteransprüche.

Die Erfindung wird nachfolgend anhand von Figuren im Zusammenhang mit einem Ausführungsbeispiel näher erläutert. Es zeigen:
- Figur 1: eine Schnittansicht durch einen Halbleiterkörper, welcher nach dem erfindungsgemäßen Verfahren hergestellt wird, in einem frühen Prozeßschritt,
- Figur 2: den Halbleiterkörper von Figur 1 in einem späteren Prozeßschritt,
- Figur 3: den Halbleiterkörper der Figur 2 in einem noch späteren Prozeßschritt,
- Figur 4: den Halbleiterkörper der Figur 3 in einem noch späteren Prozeßschritt.
- Figuren 5 bis 7: einen Halbleiterkörper nach dem Stand der Technik in verschiedenen Stadien seiner Herstellung, jeweils im Schnittbild.

In den nachfolgenden Figuren bezeichnen, sofern nicht anders angegeben, gleiche Bezugszeichen gleiche Teile mit gleicher Bedeutung.

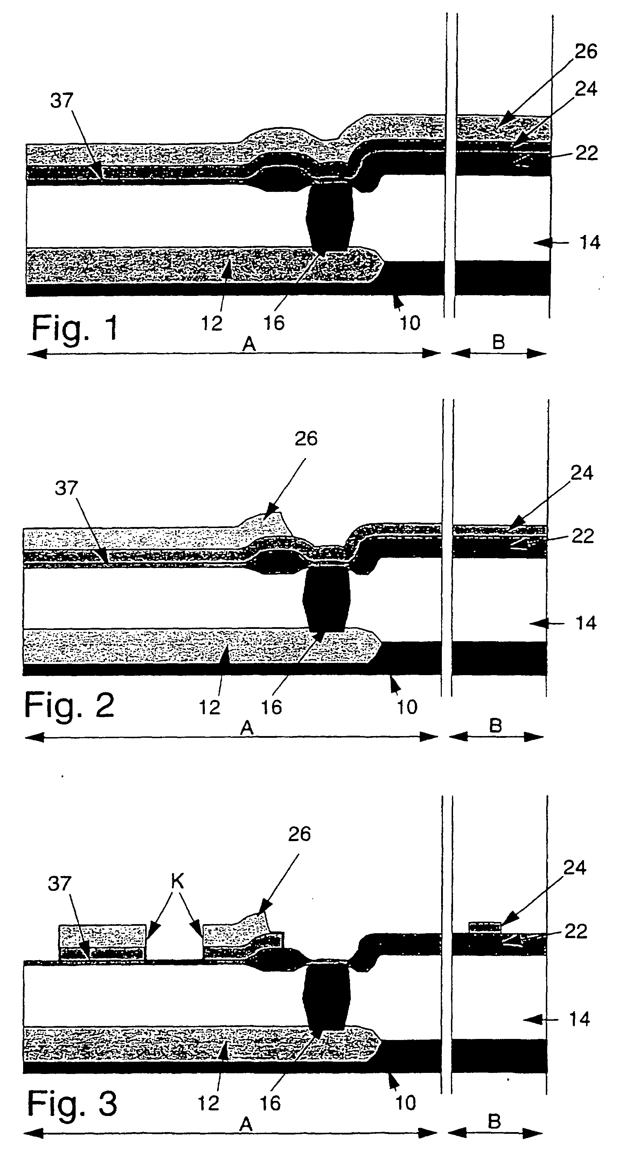

In Figur 1 ist die teilweise Schnittansicht durch einen Halbleiterkörper, in welchem ein Bereich A mit selbstjustierender Struktur und ein übriger Bereich B integriert ist, dargestellt. Figur 1 zeigt einen frühen Prozeßschritt während des Herstellverfahrens. Die in Figur 1 dargestellte Struktur des Halbleiterkörpers kann beispielsweise durch Verfahrensschritte, wie diese in DE 44 34 108 A1 beschrieben sind, erreicht werden. Deshalb wird ausdrücklich zum Zwecke der Offenbarung auf dieses Dokument Bezug genommen.

Der Halbleiterkörper weist ein p-dotiertes Substrat 10 auf, das sich über den gesamten Halbleiterkörper lateral erstreckt. Im Bereich A ist eine Buried-Layer 12 im Substrat 10 eingebettet. Über dem Buried-Layer 12 befindet sich eine n-dotierte Epitaxieschicht, die von einem sich vertikal zur oberen Hauptfläche des Halbleiterkörpers erstreckenden Tiefdiffusionsgebiet 16 durchtrennt ist. Hierdurch wird im Bereich A eine Wanne 14 gebildet. In dieser Wanne 14 sitzen später (vgl. Figur 4) p-dotierte Wannen 18, die jedoch nicht zum Buried-Layer 12 heranreichen. Auf dem gesamten Halbleiterkörper ist eine Isolationsschicht 22, hier eine FOX-Schicht, aufgebracht. Diese Isolationsschicht 22 wird mittels einer Standard-Fototechnik und naßchemischer Ätzung strukturiert, wobei der Oxidwinkel dieser Isolationsschicht 22 mit einer Vorimplantation niedriger Dosis eingestellt werden oder mittels eines LOCOS-Prozeß hergestellt werden kann. Im Anschluß daran wird in vorgegebenen Bereichen ein Gateoxid 37 auf den Halbleiterkörper aufgebracht.

Im nächsten Schritt wird auf die strukturierte Isolationsschicht 22 und Gateoxidschicht 37 eine Halbleiterschicht 24, z. B. eine hochdotierte Polysiliziumschicht, aufgebracht. Diese Halbleiterschicht 24 wird auf hohe Leitfähigkeit mittels Ofenbelegung dotiert. Aus dieser Halbleiterschicht 24 werden später Gateelektroden im Bereich A und z.B. Widerstände, Leitbahnen, Feldplatten oder weitere Gatelektroden im Bereich B erzeugt. Im nächsten Schritt wird ganzflächig auf diese Halbleiterschicht 24 eine weitere Isolationsschicht 26 aufgebracht. Diese Isolationsschicht 26 kann ein- oder mehrlagig ausgebildet sein. Die bisher beschriebene Struktur zeigt Figur 1.

Die Isolierschicht 26 kann beispielsweise eine TEOS-Schicht sein. Vorzugsweise ist die Isolierschicht 26 eine Doppelschicht aus einem dotierten Oxid und einem undotierten Oxid.

Wie aus Figur 2 ersichtlich, wird im nächsten Prozeßschritt mittels Fototechnik und anschließendem Ätzvorgang die Isolationsschicht 26 so strukturiert, daß diese im Bereich B vollständig entfernt ist und im Bereich A, in dem selbstjustierende Kontakte vorhanden sein sollen, zumindest noch teilweise stehen bleibt. Der Ätzvorgang kann beispielsweise durch naßchemisches Ätzen realisiert sein. Im dargestellten Ausführungsbeispiel ist die Isolationsschicht 26 links vom Tiefdiffusionsgebiet 16 vorhanden, während sie über dem Tiefdiffusionsgebiet 16 und rechts davon weggeätzt ist. Es muß bei diesem Prozeßschritt unbedingt sichergestellt werden, daß die Isolationsschicht 26 im Bereich der später zu realisierenden selbstjustierenden Kontakte, also dort, wo im Bereich A später die p⁺-dotierte Wanne 18 (vgl. hierzu Figur 4) vorhanden ist, stehenbleibt.

In einem nächsten Prozeßschritt wird mittels Fototechnik und anschließendem Ätzvorgang die Halbleiterschicht 24 und in Abschnitten, in denen die Isolationsschicht 26 noch über der Halbleiterschicht 24 sitzt, die Isolationsschicht 26 zusammen mit der Halbleiterschicht 24 gemeinsam strukturiert. Der sich hierbei ergebende Halbleiterkörper ist in Figur 3 dargestellt. Der erwähnte Ätzvorgang sorgt im Bereich A zu einem Durchätzen der Isolationsschicht 24 und der darunterliegenden Halbleiterschicht 24 bis zur Oxidschicht 22. Die sich hierbei ergebenden Kanten, an denen später sogenannte Spacer 30 (vgl. hier ebenfalls Figur 4) angebracht werden, sind in Figur 3 mit K bezeichnet. In den übrigen Bereichen, bei denen keine Isolierschicht 26 auf der Halbleiterschicht 24 sitzt, wird lediglich die Halbleiterschicht 24 strukturiert. Im Bereich B kann die strukturierte Halbleiterschicht 24 zur Realisierung von z. B. Leiterbahnen und/oder Widerständen erfolgen.

An den erwähnten Kanten K (vgl. Figur 3) wird in einem nächsten Prozeßschritt durch Aufbringen einer weiteren Oxidschicht 28 unter Verwendung einer Standard-Fototechnik und anschließender Ätzung ein Spacer 30 angeformt (vgl. Figur 4). Die erwähnte Oxidschicht 28, die zunächst ganzflächig auf den Halbleiterkörper aufgetragen bzw. abgeschieden wird, umgibt auch die Halbleiterschicht 24 im Bereich B. Die Halbleiterschicht 24 dient im Bereich B als Leiterbahn oder Widerstand. Die Oxidschicht 28 isoliert diese Halbleiterschicht 24 im Bereich B gegen eine darüberliegende Metallisierungsschicht 32.

Im einzelnen können nach dem in Figur 3 dargestellten Prozeßschnitt z. B. folgende weitere Schritte durchgeführt werden, um den in Figur 4 gezeigten Halbleiterkörper zu bilden:
- ein p-Dotierstoff wird implantiert zur Bildung der Wanne 18;
- ein n⁺-Dotierstoff wird implantiert zur Bildung von n⁺-Gebieten 20;
- ganzflächig wird eine weitere Isolationsschicht 28 auf den Halbleiterkörper aufgebracht;
- die weitere Isolationsschicht 28 wird mittels Fototechnik und Ätzung bis zur Halbleiteroberfläche strukturiert;
- der Halbleiterkörper wird unter Verwendung der weiteren Isolationsschicht 28 als Maske geätzt;
- ein p⁺-Dotierstoff vom zweiten Leitfähigkeitstyp wird unter Verwendung der weiteren Isolationsschicht 28 als Maske implantiert; und
- mindestens eine Metallisierungsschicht 32, 34 wird auf den Halbleiterkörper abgeschieden.

Ein Vergleich der Figuren 4 und 7 zeigt deutlich, daß die Metallisierungsschicht 32 beim erfindungsgemäßen Verfahren (vgl. Figur 4) eine deutlich geringere Stufe zu überwinden hat und daher in der Fertigungstechnik leichter zu realisieren ist als beim bekannten Verfahren nach dem Stand der Technik (vgl. Figur 7). Dies bedingt insgesamt eine höhere Packungsdichte im Bereich B des im Halbleiterkörper integrierten Schaltkreises.

Zusammenfassend kann also festgestellt werden, daß bei dem Verfahren nach der vorliegenden Erfindung die für die selbstjustierende Technik notwendige Isolationsschicht 26 in allen Teilen des Halbleiterkörpers, wo keine selbstjustierende Kontakte verwendet werden, wieder entfernt wird. Dies erfordert zwar eine zusätzliche Maskenebene und eine Ätzung der Isolierschicht. Diese beiden zusätzlichen Prozeßschritte führen jedoch nur zu einem geringfügig höheren Herstellaufwand des Halbleiterkörpers. Durch diesen geringfügig erhöhten Herstellaufwand wird jedoch eine höhere Packungsdichte des gesamten integrierten Schaltkreises ermöglicht.

## Patentansprüche

1. Verfahren zum Herstellen eines Halbleiterkörpers mit einem eine selbstjustierende Struktur aufweisenden ersten Bereich (A) und einem übrigen zweiten Bereich (B) und folgenden Verfahrensschritten:
- eine erste Oxidschicht (22) wird auf eine obere Hauptfläche des Halbleiterkörpers aufgebracht und strukturiert;
- auf die Oxidschicht (22) wird eine Halbleiterschicht (24) aufgebracht;
- auf die Halbleiterschicht (24) wird eine Isolationsschicht (26) aufgebracht;
- die Isolationsschicht (26) wird mittels Fototechnik und anschließendem Ätzen so strukturiert, daß diese im zweiten Bereich (B) vollständig entfernt ist und im ersten Bereich (A) mindestens teilweise noch auf der Halbleiterschicht (24) sitzt;
**gekennzeichnet durch** den weiteren Verfahrensschritt:
- mittels Fototechnik und anschließendem Ätzen wird die Halbleiterschicht (24) und in Abschnitten, bei denen die Isolationsschicht (26) über der Halbleiterschicht (24) sitzt, die Isolationsschicht (26) zusammen mit der Halbleiterschicht (24) strukturiert.

2. Verfahren nach Anspruch 1,
**dadurch gekennzeichnet, daß** für die Halbleiterschicht (24) Polysilizium verwendet wird.

3. Verfahren nach Anspruch 1 oder 2,
**dadurch gekennzeichnet, daß** mittels Fototechnik und anschließendem Ätzvorgang mindestens teilweise die Isolationsschicht (26) auch über der verbleibenden Halbleiterschicht (24) im ersten Bereich (A) entfernt wird.

4. Verfahren nach einem der Ansprüche 1 bis 3,
**dadurch gekennzeichnet, daß** im ersten Bereich (A) eine Vielzahl von DMOS-FETs integriert sind.

5. Verfahren nach einem der Ansprüche 1 bis 4,
**dadurch gekennzeichnet, daß** die auf der Halbleiterschicht (24) sitzende Isolationsschicht (26) aus mindestens zwei Lagen (26a, 26b) gebildet ist.

6. Verfahren nach einem der Ansprüche 1 bis 5,
**dadurch gekennzeichnet, daß** die auf der Halbleiterschicht (24) sitzende Isolationsschicht (26) mindestens annähernd doppelt so hoch wie die Halbleiterschicht (24) ausgebildet ist.

7. Verfahren nach einem der Ansprüche 1 bis 6,
**dadurch gekennzeichnet, daß** nach dem Entfernen der auf der Halbleiterschicht (24) sitzenden Isolationsschicht (26) folgende Verfahrensschritte durchgeführt werden:
- ein erster Dotierstoff eines ersten Leitfähigkeitstyps wird implantiert;
- ein zweiter Dotierstoff vom zweiten Leitfähigkeitstyp wird implantiert;
- ganzflächig wird eine weitere Isolationsschicht (28) auf den Halbleiterkörper aufgebracht;
- die weitere Isolationsschicht (28) wird mittels Fototechnik und anisotroper Ätzung bis zur Halbleiteroberfläche strukturiert;
- der Halbleiterkörper wird unter Verwendung der weiteren Isolationsschicht (28) als Maske anisotrop geätzt;
- ein dritter Dotierstoff vom zweiten Leitfähigkeitstyp wird unter Verwendung der weiteren Isolationsschicht (28) als Maske implantiert; und
- mindestens eine Metallisierungsschicht (32, 34) wird auf den Halbleiterkörper abgeschieden.

8. Verfahren nach Anspruch 7,
**dadurch gekennzeichnet, daß** die weitere Isolationsschicht (28) unter Bildung von seitlich an den Kanten der im ersten Bereich (A) befindlichen übereinanderliegenden Halbleiterschicht (24) und darüberliegenden Isolationsschicht (26) angrenzenden Spacer (30) strukturiert wird.

## Claims

1. Process for the production of a semiconductor body with a first region (A) that has a self-aligning structure, and with a further second region (B), and with the following process steps:
- a first oxide layer (22) is applied to an upper main surface of the semiconductor body and is structured;
- a semiconductor layer (24) is applied to the oxide layer (22);
- an insulation layer (26) is applied to the semiconductor layer (24);
- the insulation layer (26) is structured using a photographic technique and subsequent etching, in such a way that it is fully removed in the second region (B) and at least partially still lies on the semiconductor layer (24) in the first region (A);
**characterized in that** the further process step:
- using a photographic technique and subsequent etching, the semiconductor layer (24) and, in sections where the insulation layer (26) lies over the semiconductor layer (24), the insulation layer (26) together with the semiconductor layer (24) are structured.

2. Process according to Claim 1, **characterized in that** polysilicon is used for the semiconductor layer (24).

3. Process according to Claim 1 or 2, **characterized in that**, using a photographic technique and a subsequent etching process, the insulation layer (26) is also at least partially removed over the remaining semiconductor layer (24) in the first region (A).

4. Process according to one of Claims 1 to 3, **characterized in that** a plurality of DMOS FETs are integrated in the first region (A).

5. Process according to one of Claims 1 to 4, **characterized in that** the insulation layer (26) lying on the semiconductor layer (24) is formed by at least two levels (26a, 26b).

6. Process according to one of Claims 1 to 5, **characterized in that** the height of the insulation layer (26) lying on the semiconductor layer (24) is at least approximately two times that of the semiconductor layer (24).

7. Process according to one of Claims 1 to 6, **characterized in that**, after the insulation layer (26) lying on the semiconductor layer (24) has been removed, the following process steps are carried out:
- a first dopant of a first conductivity type is implanted;
- a second dopant of the second conductivity type is implanted;
- a further insulation layer (28) is applied surface-wide to the semiconductor body;
- the further insulation layer (28) is structured using a photographic technique and anisotropic etching as far as the semiconductor surface;
- the semiconductor body is etched anisotropically using the further insulation layer (28) as a mask;
- a third dopant of the second conductivity type is implanted using the further insulation layer (28) as a mask; and
- at least one metallization layer (32, 34) is deposited on the semiconductor body.

8. Process according to Claim 7, **characterized in that** the further insulation layer (28) is structured to form spacers (30) laterally adjoining the edges of the semiconductor layer (24) and the insulation layer (26) lying above it in the first region (A).

## Revendications

1. Procédé de fabrication d'un corps semi-conducteur ayant une première zone (A) présentant une structure auto-ajustable et une deuxième zone (B) restante, comprenant les étapes de procédé suivantes :
- on dépose et on structure une première couche d'oxyde (22) sur une surface principale supérieure du corps semi-conducteur ;
- déposer une couche semi-conductrice (24) sur la couche d'oxyde (22) ;
- on dépose une couche d'isolation (26) sur la couche semi-conductrice (24) ;
- on structure la couche d'isolation (26) par une phototechnique et ensuite par une gravure de telle sorte que celle-ci soit entièrement écartée de la deuxième zone (B) et se trouve au moins partiellement encore sur la couche semi-conductrice (24) dans la première zone (A) ;
**caractérisé par**
une autre étape de procédé par laquelle :
- on structure, par une phototechnique et ensuite par une gravure, la couche semi-conductrice (24) et, dans les parties où la couche d'isolation (26) se trouve sur la couche semi-conductrice (24), la couche d'isolation (26) conjointement avec la couche semi-conductrice (24).

2. Procédé selon la revendication 1,
**caractérisé en ce que**
pour la couche semi-conductrice (24), on utilise un polysilicium.

3. Procédé selon la revendication 1 ou 2,
**caractérisé en ce qu'**
au moyen de la phototechnique et ensuite du processus de gravure, la couche d'isolation (26) est également écartée au moins partiellement sur la couche semi-conductrice restante (26) dans la première zone (A).

4. Procédé selon l'une des revendications 1 à 3,
**caractérisé en ce que**
dans la première zone (A), une quantité de DMOS-FET est intégrée.

5. Procédé selon l'une des revendications 1 à 4,
**caractérisé en ce que**
la couche d'isolation (26) se trouvant sur la couche semi-conductrice (24) est formée d'au moins deux couches (26a, 26b).

6. Procédé selon l'une des revendications 1 à 5,
**caractérisé en ce que**
la couche d'isolation (26) se trouvant sur la couche semi-conductrice (24) est environ au moins deux fois aussi haute que la couche semi-conductrice (24).

7. Procédé selon l'une des revendications 1 à 6,
**caractérisé en ce que**
après avoir éloigné la couche d'isolation (26) se trouvant sur la couche semi-conductrice (24), on réalise les étapes de procédé suivantes :
- on implante un premier matériau d'apport d'un premier type de conductivité ;
- on implante un deuxième matériau d'apport d'un deuxième type de conductivité ;
- on dépose sur toute la surface une autre couche d'isolation (28) sur le corps semi-conducteur ;
- on structure l'autre couche d'isolation (28) par une phototechnique et par une gravure anisotrope jusque sur la surface semi-conductrice ;
- on effectue une gravure anisotrope du corps semi-conducteur en utilisant l'autre couche d'isolation (28) comme masque ;
- on implante un troisième matériau d'apport d'un deuxième type de conductivité en utilisant l'autre couche d'isolation (28) comme masque ; et
- on isole au moins une couche de métallisation (32, 32) sur le corps semi-conducteur.

8. Procédé selon la revendication 8,
**caractérisé en ce que**
l'autre couche d'isolation (28) est structurée en formant un espaceur (30) adjacent latéralement au niveau des bords des couches semiconductrices (24) se chevauchant dans la première zone (A) et de la couche d'isolation (26) située au-dessus.
